(19) Europäisches Patentamt
European Patent Office
Office européen des brevets

(11) **EP 2 567 209 B1**

## (12) EUROPEAN PATENT SPECIFICATION

(45) Date of publication and mention
of the grant of the patent:
**08.07.2020 Bulletin 2020/28**

(51) Int Cl.:
***G01M 11/02*** *(2006.01)*     ***G01B 11/24*** *(2006.01)*
***G01N 21/01*** *(2006.01)*

(21) Application number: **11778115.3**

(22) Date of filing: **02.05.2011**

(86) International application number:
**PCT/US2011/034833**

(87) International publication number:
**WO 2011/139982 (10.11.2011 Gazette 2011/45)**

(54) **DETERMINATION OF MATERIAL OPTICAL PROPERTIES FOR OPTICAL METROLOGY OF STRUCTURES**

BESTIMMUNG OPTISCHER MATERIALEIGENSCHAFTEN ZUR OPTISCHEN MESSUNG VON STRUKTUREN

DÉTERMINATION DE PROPRIÉTÉS OPTIQUES DE MATÉRIAU POUR MÉTROLOGIE OPTIQUE DE STRUCTURES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.05.2010 US 775392**

(43) Date of publication of application:
**13.03.2013 Bulletin 2013/11**

(73) Proprietor: **KLA-Tencor Corporation
Milpitas, CA 95035 (US)**

(72) Inventors:
• **MADSEN, Jonathan, Michael
Sunnyvale
CA 94086 (US)**

• **YANG, Weidong
San Francisco
CA 94118 (US)**

(74) Representative: **FRKelly
27 Clyde Road
Dublin D04 F838 (IE)**

(56) References cited:
| | |
|---|---|
| WO-A1-99/45340 | US-A1- 2002 033 954 |
| US-A1- 2002 088 952 | US-A1- 2003 187 602 |
| US-A1- 2004 233 441 | US-A1- 2005 018 190 |
| US-A1- 2006 064 280 | US-A1- 2007 002 337 |
| US-A1- 2008 129 986 | US-A1- 2010 042 388 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### TECHNICAL FIELD

Embodiments of the present invention are in the field of Optical Metrology, and, more particularly, relate to the determination of material optical properties for optical metrology of structures.

### BACKGROUND

For the past several years, a rigorous couple wave approach (RCWA) and similar algorithms have been widely used for the study and design of diffraction structures. In the RCWA approach, the profiles of periodic structures are approximated by a given number of sufficiently thin planar grating slabs. Specifically, RCWA involves three main steps, namely, the Fourier expansion of the field inside the grating, calculation of the eigenvalues and eigenvectors of a constant coefficient matrix that characterizes the diffracted signal, and solution of a linear system deduced from the boundary matching conditions. RCWA divides the problem into three distinct spatial regions: 1) the ambient region supporting the incident plane wave field and a summation over all reflected diffracted orders, 2) the grating structure and underlying non-patterned layers in which the wave field is treated as a superposition of modes associated with each diffracted order, and 3) the substrate containing the transmitted wave field.

The accuracy of the RCWA solution depends, in part, on the number of terms retained in the space-harmonic expansion of the wave fields, with conservation of energy being satisfied in general. The number of terms retained is a function of the number of diffraction orders considered during the calculations. Efficient generation of a simulated diffraction signal for a given hypothetical profile involves selection of the optimal set of diffraction orders at each wavelength for both transverse-magnetic (TM) and/or transverse-electric (TE) components of the diffraction signal. Mathematically, the more diffraction orders selected, the more accurate the simulations. However, the higher the number of diffraction orders, the more computation is required for calculating the simulated diffraction signal. Moreover, the computation time is a nonlinear function of the number of orders used.

US2010/042388 discloses a method for improving computation efficiency for diffraction signals in optical metrology.

US2008/129986 describes an optical metrology apparatus for measuring periodic structures using multiple incident azimuthal (phi) and polar (theta) incident angles.

### SUMMARY OF THE INVENTION

Embodiments of the present invention relate to the determination of material optical properties for optical metrology of structures.

An aspect of at least some of the embodiments of the invention includes a method of determining a material optical property for optical metrology of a structure. A set of diffraction orders is simulated for a grating structure based on two or more azimuth angles and on one or more angles of incidence. A simulated spectrum is then provided based on the set of diffraction orders. In one embodiment, the method further includes comparing the simulated spectrum to a sample spectrum.

Another aspect of at least some of the embodiments of the invention includes a method of determining a material optical property for optical metrology of a structure. A set of diffraction orders is simulated for a grating structure based on two or more angles of incidence. A simulated spectrum is then provided based on the set of diffraction orders. The method further includes comparing the simulated spectrum to a sample spectrum.

Another aspect of at least some of the embodiments of the invention includes a machine-accessible storage medium having instructions stored thereon which cause a data processing system to perform a method of determining a material optical property for optical metrology of a structure. In the method, a set of diffraction orders is simulated for a grating structure based on two or more azimuth angles and on one or more angles of incidence. A simulated spectrum is then provided based on the set of diffraction orders.

Yet another aspect of at least some of the embodiments of the invention includes a machine-accessible storage medium having instructions stored thereon which cause a data processing system to perform a method of determining a material optical property for optical metrology of a structure. In the method, a set of diffraction orders is simulated for a grating structure based on two or more angles of incidence. A simulated spectrum is then provided based on the set of diffraction orders.

### BRIEF DESCRIPTION OF THE DRAWINGS

Figure 1 depicts a Flowchart representing an exemplary series of operations for determining and utilizing profile parameters for automated process and equipment control, in accordance with an embodiment of the present invention.

Figure 2 is an exemplary block diagram of a system for determining and utilizing profile parameters for automated process and equipment control, in accordance with an embodiment of the present invention.

Figure 3 depicts a Flowchart representing operations in a method of determining a material optical property for optical metrology of a structure, in accordance with an embodiment of the present invention.

Figure 4A depicts a periodic grating having a profile that varies in the x-y plane, in accordance with an embodiment of the present invention.

Figure 4B depicts a periodic grating having a profile that varies in the x-direction but not in the y-direction, in accordance with an embodiment of the present invention.

Figure 5 depicts a Flowchart representing operations in a method of determining a material optical property for optical metrology of a structure, in accordance with an embodiment of the present invention.

Figure 6 illustrates a decision chart including both refinement and testing aspects of a method of determining a material optical property for optical metrology of a structure, in accordance with an embodiment of the present invention.

Figure 7 illustrates a cross-sectional view of a representative material stack for which a material optical property for optical metrology is determined, in accordance with an embodiment of the present invention.

Figure 8 is an architectural diagram illustrating the utilization of optical metrology to determine the profiles of structures on a semiconductor wafer, in accordance with an embodiment of the present invention.

Figure 9 illustrates a block diagram of an exemplary computer system, in accordance with an embodiment of the present invention.

**DETAILED DESCRIPTION**

The invention is as defined in the appended claims. Approaches for the determination of material optical properties for optical metrology of structures are described herein. In the following description, numerous specific details are set forth, such as "n,k" refinement approaches, in order to provide a thorough understanding of embodiments of the present invention. It will be apparent to one skilled in the art that embodiments of the present invention may be practiced without these specific details. In other instances, well-known processing steps, such as fabricating stacks of patterned material layers, are not described in detail in order to not unnecessarily obscure embodiments of the present invention. Furthermore, it is to be understood that the various embodiments shown in the Figures are illustrative representations and are not necessarily drawn to scale.

Disclosed herein are methods of determining material optical properties for optical metrology of structures. In one embodiment, a method includes simulating a set of diffraction orders for a grating structure based on two or more azimuth angles and on one or more angles of incidence. A simulated spectrum is then provided based on the set of diffraction orders. In one embodiment, a method includes simulating a set of diffraction orders for a grating structure based on two or more angles of incidence. A simulated spectrum is then provided based on the set of diffraction orders.

Orders of a diffraction signal may be simulated as being derived from a periodic structure. The zeroth order represents a diffracted signal at an angle equal to the angle of incidence of a hypothetical incident beam, with respect to the normal N of the periodic structure. Higher diffraction orders are designated as +1, +2, +3, -1, -2, - 3, etc. Other orders known as evanescent orders may also be considered. In accordance with an embodiment of the present invention, a simulated diffraction signal is generated for use in optical metrology.

Optical properties of materials, such as index of refractivity and coefficient of extinction, (n & k), in wafer structures may be modeled for use in optical metrology. In accordance with an embodiment of the present invention, optical properties of materials can be "floated" or "fixed", along with other variables of an optical metrology model, for measuring wafer structures. Conventionally, an unpatterned wafer may used to determine the n & k of the material layer which then may be used to fix the n & k in the model. However, a bare wafer may not capture the potential change of n & k when the wafer undergoes certain fabrication steps. Instead, an approach including floating more variables in the optical metrology model yields improved results initially. But as the model becomes more complex, simulation takes more time and computer resources. Moreover, floating many variables may also result in less sensitivity of the measurement of structures, making the optical metrology model produce unreliable results. An example of n & k models are Cauchy and Tauc Laurentz. In the most basic equation for n:

$$n = a + b/\lambda + c/\lambda^2 + d/\lambda^3 \dots$$

(eq. 1)

As can be seen from eq. 1, in a multi-layer structure, the number of variables in the optical metrology model rises rapidly, possibly creating stability problems in the measurement due to the high number of floated parameters and parameter correlation.

In accordance with the present invention, approaches are provided to determine a value for the optical properties of materials (n & k) in a wafer in order to meet optical metrology sensitivity and accuracy metrics criteria. In a first embodiment, two or more azimuth angles are used in measuring and simulating a diffraction signal. In one such embodiment, using prior knowledge or expert experience with the wafer application, n & k variables are selected for floating. An optical metrology device with adjustable azimuth angle may be used to measure the diffraction signal off the structure at two or more azimuth angles. Simulated signals are generated using the two or more azimuth angles. The two or more measured signals are combined with the two or more simulated signals by joint regression. Sensitivity and accuracy of determined profile parameters of the structure are then tested.

In accordance with at the present invention, n,k refinement is performed for grating structures. In one embodiment, film dispersion is considered and techniques of using multiple angles of incidence are performed to obtain accurate dispersions on films. Grating samples are used. In a specific embodiment, dispersion in a grating is different than a film pad due to processing or, in another embodiment, film pads are not available. In an embodiment, techniques to obtain accurate n,k dispersion models in a grating are provided. In one embodiment, such a technique includes multiple azimuth angle measurements and multiple angle of incidence measurements, or a combo of azimuth angle and angle of incidence measurements is used. Some embodiments allow for "over-determination" of problem and optimization of n,k from a grating structure. In a specific embodiment, a number of n,k additive film stacks required for calculation is reduced for increased time to results. In another specific embodiment, n,k of a grating structure is captured for film or grating differences.

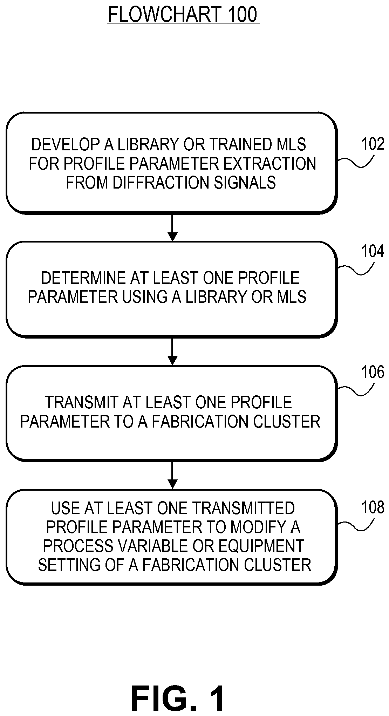

Calculations based simulated diffraction orders may be indicative of profile parameters for a patterned film, such as a patterned semiconductor film or photo-resist layer, and may be used for calibrating automated processes or equipment control. Figure 1 depicts a Flowchart 100 representing an exemplary series of operations for determining and utilizing profile parameters for automated process and equipment control, in accordance with an embodiment of the present invention.

Referring to operation 102 of Flowchart 100, a library or trained machine learning systems (MLS) is developed to extract profile parameters from a set of measured diffraction signals. In operation 104, at least one profile parameter of a structure is determined using the library or the trained MLS. In operation 106, the at least one profile parameter is transmitted to a fabrication cluster configured to perform a processing step, where the processing step may be executed in the semiconductor manufacturing process flow either before or after measurement step 104 is made. In operation 108, the at least one transmitted profile parameter is used to modify a process variable or equipment setting for the processing step performed by the fabrication cluster. For a more detailed description of machine learning systems and algorithms, see U.S. Patent Application Ser. No. 10/608,300, entitled OPTICAL METROLOGY OF STRUCTURES FORMED ON SEMICONDUCTOR WAFERS USING MACHINE LEARNING SYSTEMS, filed on June 27, 2003. For a description of diffraction order optimization for two dimensional repeating structures, see U.S. Patent Application Ser. No. 11/388,265, entitled OPTIMIZATION OF DIFFRACTION ORDER SELECTION FOR TWO-DIMENSIONAL STRUCTURES, filed on March 24, 2006.

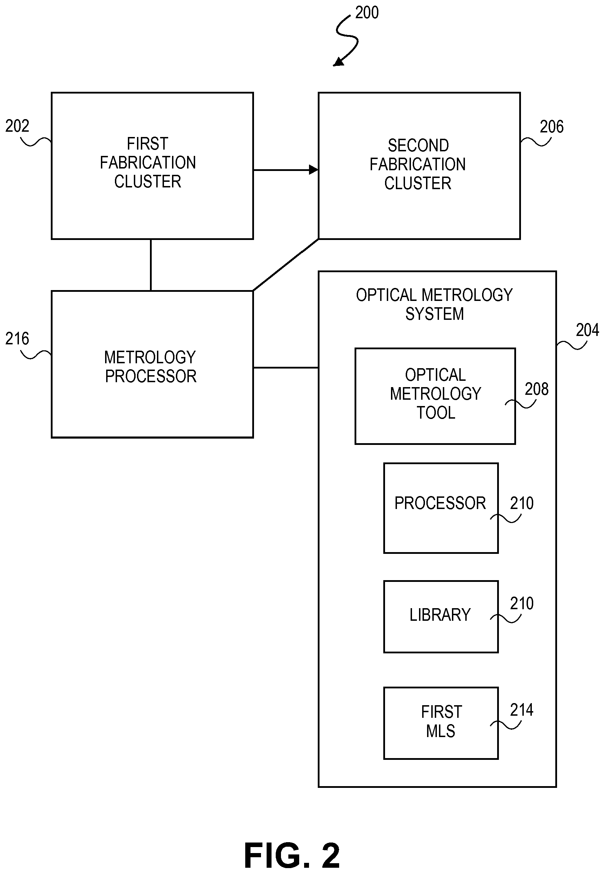

Figure 2 is an exemplary block diagram of a system 200 for determining and utilizing profile parameters for automated process and equipment control, in accordance with an embodiment of the present invention. System 200 includes a first fabrication cluster 202 and optical metrology system 204. System 200 also includes a second fabrication cluster 206. Although the second fabrication cluster 206 is depicted in Figure 2 as being subsequent to first fabrication cluster 202, it should be recognized that second fabrication cluster 206 can be located prior to first fabrication cluster 202 in system 200 (and, e.g., in the manufacturing process flow).

A photolithographic process, such as exposing and developing a photo-resist layer applied to a wafer, can be performed using first fabrication cluster 202. In one exemplary embodiment, optical metrology system 204 includes an optical metrology tool 208 and processor 210. Optical metrology tool 208 is configured to measure a diffraction signal obtained from the structure. If the measured diffraction signal and the simulated diffraction signal match, one or more values of the profile parameters are determined to be the one or more values of the profile parameters associated with the simulated diffraction signal.

In one exemplary embodiment, optical metrology system 204 can also include a library 212 with a plurality of simulated diffraction signals and a plurality of values of one or more profile parameters associated with the plurality of simulated diffraction signals. As described above, the library can be generated in advance. Metrology processor 210 can compare a measured diffraction signal obtained from a structure to the plurality of simulated diffraction signals in the library. When a matching simulated diffraction signal is found, the one or more values of the profile parameters associated with the matching simulated diffraction signal in the library is assumed to be the one or more values of the profile parameters used in the wafer application to fabricate the structure.

System 200 also includes a metrology processor 216. In one exemplary embodiment, processor 210 can transmit the one or more values of the one or more profile parameters to metrology processor 216. Metrology processor 216 can then adjust one or more process parameters or equipment settings of first fabrication cluster 202 based on the one or more values of the one or more profile parameters determined using optical metrology system 204. Metrology processor 216 can also adjust one or more process parameters or equipment settings of the second fabrication cluster 206 based on the one or more values of the one or more profile parameters determined using optical metrology system 204. As noted above, fabrication cluster 206 can process the wafer before or after fabrication cluster 202. In another exemplary embodiment, processor 210 is configured to train machine learning system 214 using the set of measured diffraction signals as inputs to machine learning system 214 and profile parameters as the expected outputs of machine learning system 214.

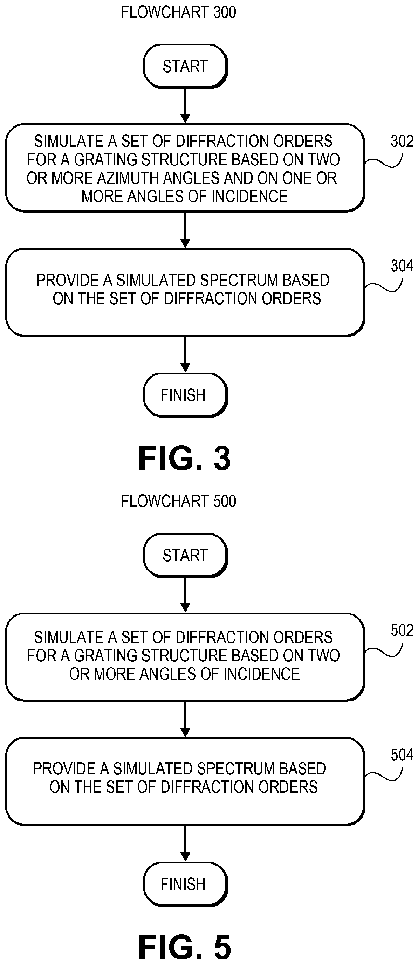

In an aspect of the present invention, determination of a material optical property for optical metrology of a structure, obtained from simulated diffractions signals, includes simulating a set of diffraction orders for a grating structure based on two or more azimuth angles and on one or more angles of incidence. Figure 3 depicts a Flowchart 300 representing operations in a method of determining a material optical property for optical metrology of a structure, in accordance with an embodiment of the present invention.

Referring to operation 302 of Flowchart 300, a method of determining a material optical property for optical metrology of a structure includes simulating a set of diffraction orders for a grating structure based on two or more azimuth angles and on one or more angles of incidence. In accordance with an embodiment of the present invention, simulating the set of diffraction orders for the grating structure includes using a dense grating structure in combination with an isolated structure. In an embodiment, simulating the set of diffraction orders is based on two or more angles of incidence.

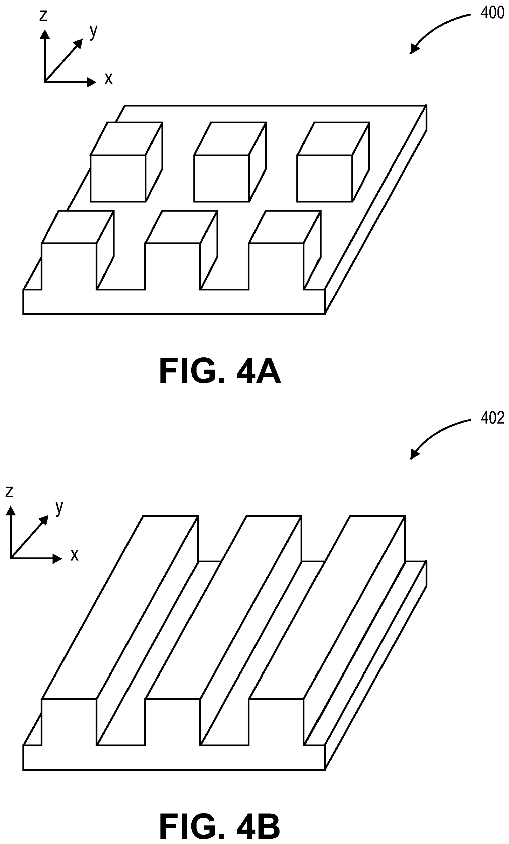

In an embodiment, simulating the set of diffraction orders for the grating structure includes using a three-dimensional grating structure. The term "three-dimensional grating structure" is used herein to refer to a structure having an x-y profile that varies in two dimensions in addition to a depth in the z-direction. For example, Figure 4A depicts a periodic grating 400 having a profile that varies in the x-y plane, in accordance with an embodiment of the present invention. The profile of the periodic grating varies in the z-direction as a function of the x-y profile.

In an embodiment, simulating the set of diffraction orders for the grating structure includes using a two-dimensional grating structure. The term "two-dimensional grating structure" is used herein to refer to a structure having an x-y profile that varies in only one dimension in addition to a depth in the z-direction. For example, Figure 4B depicts a periodic grating 402 having a profile that varies in the x-direction but not in the y-direction, in accordance with an embodiment of the present invention. The profile of the periodic grating varies in the z-direction as a function of the x profile. It is to be understood that the lack of variation in the y-direction for a two-dimensional structure need not be infinite, but any breaks in the pattern are considered long range, e.g., any breaks in the pattern in the y-direction are spaced substantially further apart than the brakes in the pattern in the x-direction.

Referring to operation 304 of Flowchart 300, the method of determining a material optical property for optical metrology of a structure also includes providing a simulated spectrum based on the set of diffraction orders.

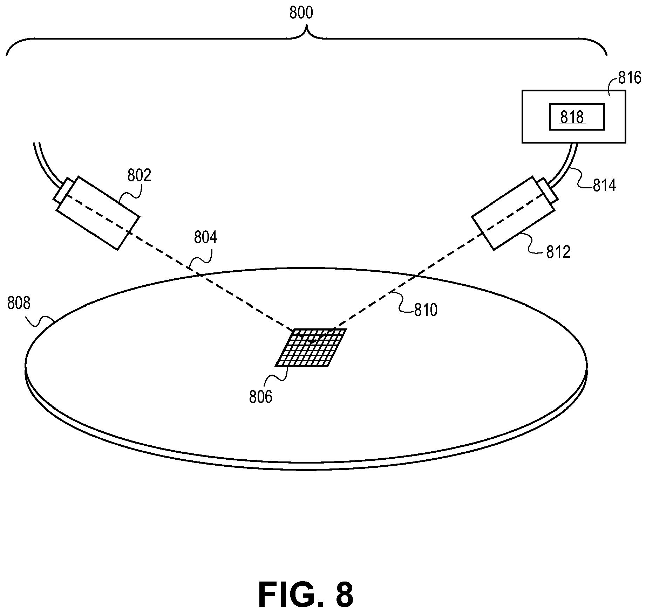

In accordance with the present invention, the method of determining a material optical property for optical metrology of a structure further includes comparing the simulated spectrum to a sample spectrum. In one embodiment, the set of diffraction orders is simulated to represent diffraction signals from a three-dimensional grating structure generated by an ellipsometric optical metrology system, such as the optical metrology system 800 described below in association with Figure 8. However, it is to be understood that the same concepts and principles equally apply to the other optical metrology systems, such as reflectometric systems. The diffraction signals represented may account for features of the three-dimensional grating structure such as, but not limited to, profile, dimensions or material composition.

In another aspect of the present invention, determination of a material optical property for optical metrology of a structure, obtained from simulated diffractions signals, includes simulating a set of diffraction orders for a grating structure based on two or more angles of incidence. Figure 5 depicts a Flowchart 500 representing operations in a method of determining a material optical property for optical metrology of a structure, in accordance with an embodiment of the present invention.

Referring to operation 302 of Flowchart 300, a method of determining a material optical property for optical metrology of a structure includes simulating a set of diffraction orders for a grating structure based on two or more azimuth angles and on one or more angles of incidence. In accordance with an embodiment of the present invention, simulating the set of diffraction orders for the grating structure includes using a dense grating structure in combination with an isolated structure. In an embodiment, simulating the set of diffraction orders is further based on two or more azimuth angles.

In an embodiment, simulating the set of diffraction orders for the grating structure includes using a three-dimensional grating structure. The term "three-dimensional grating structure" is used herein to refer to a structure having an x-y profile that varies in two dimensions in addition to a depth in the z-direction. For example, Figure 4A depicts a periodic grating 400 having a profile that varies in the x-y plane, in accordance with an embodiment of the present invention. The profile of the periodic grating varies in the z-direction as a function of the x-y profile.

In an embodiment, simulating the set of diffraction orders for the grating structure includes using a two-dimensional grating structure. The term "two-dimensional grating structure" is used herein to refer to a structure having an x-y profile that varies in only one dimension in addition to a depth in the z-direction. For example, Figure 4B depicts a periodic grating 402 having a profile that varies in the x-direction but not in the y-direction, in accordance with an embodiment of the present invention. The profile of the periodic grating varies in the z-direction as a function of the x profile. It is to be understood that the lack of variation in the y-direction for a two-dimensional structure need not be infinite, but any breaks in the pattern are considered long range, e.g., any breaks in the pattern in the y-direction are spaced substantially further apart than the brakes in the pattern in the x-direction.

In another aspect of the present invention, determining a material optical property for optical metrology of a structure includes simulating a set of diffraction orders for a grating structure is based on two or more angles of incidence. For example, referring to operation 502 of Flowchart 500, a method of determining a material optical property for optical metrology of a structure includes simulating a set of diffraction orders for a grating structure based on two or more angles of incidence. In accordance with an embodiment of the present invention, simulating the set of diffraction orders for the grating structure includes using a dense grating structure in combination with an isolated structure. In an embodiment, simulating the set of diffraction orders is further based on one or more azimuth angles.

Referring to operation 504 of Flowchart 500, the method of determining a material optical property for optical metrology of a structure also includes providing a simulated spectrum based on the set of diffraction orders.

In accordance with the present invention, the method of determining a material optical property for optical metrology of a structure further includes comparing the simulated spectrum to a sample spectrum. In one embodiment, the set of diffraction orders is simulated to represent diffraction signals from a three-dimensional grating structure generated by an ellipsometric optical metrology system, such as the optical metrology system 800 described below in association with Figure 8. However, it is to be understood that the same concepts and principles equally apply to the other optical metrology systems, such as reflectometric systems. The diffraction signals represented may account for features of the three-dimensional grating structure such as, but not limited to, profile, dimensions or material composition.

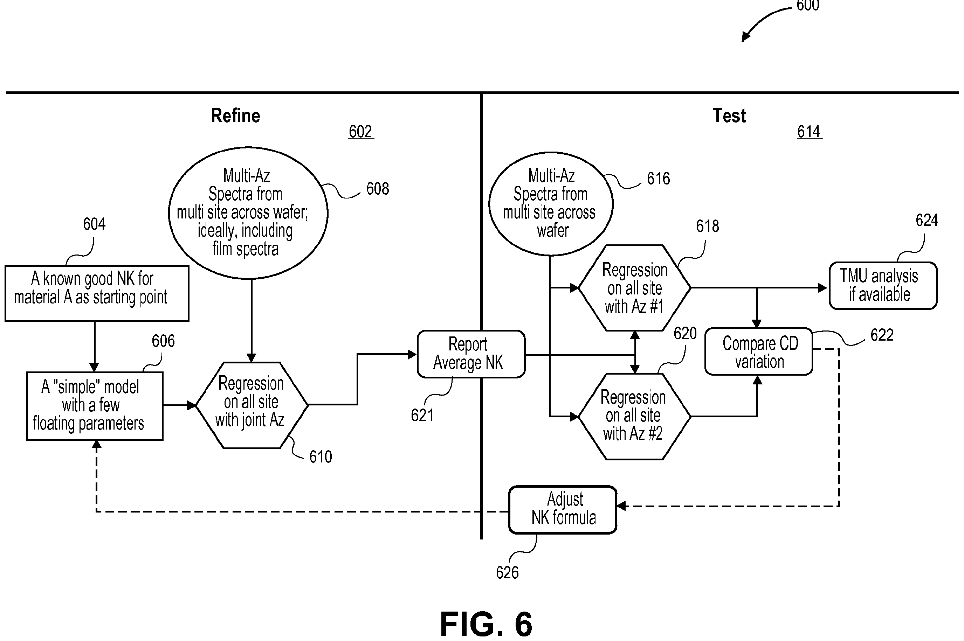

Figure 6 illustrates a decision chart 600 including both refinement and testing aspects of a method of determining a material optical property for optical metrology of a structure, in accordance with an embodiment of the present invention.

Referring to the refinement portion 602 of decision chart 600, at block 604, a known good n,k for a material is used as a starting point. At block 606, a "simple" model with a few floating parameters is used. Meanwhile, at block 608, spectra from multiple sites across a wafer, including film spectra, is determined for multiple azimuth angles. Input from blocks 606 and 608 are regressed at block 610 for a combined regression on all sites with joint azimuth angles. Then, at block 621, average n,k values are reported.

Referring to the test portion 614 of decision chart 600, at block 616, multiple azimuth spectra are obtained from across multiple sites on the wafer. A regression is performed on each individual site based on each individual azimuth angle at blocks 618 and 620. At block 622, parameters such as critical dimension (CD) variation are compared. At block 624, if available, a total measurement uncertainty (TMU) may be used as an option to check reference data. At block 626, if model data is not aligning with reference data, n,k formula values are adjusted and used to modify the models at block 606, starting the cycle over again.

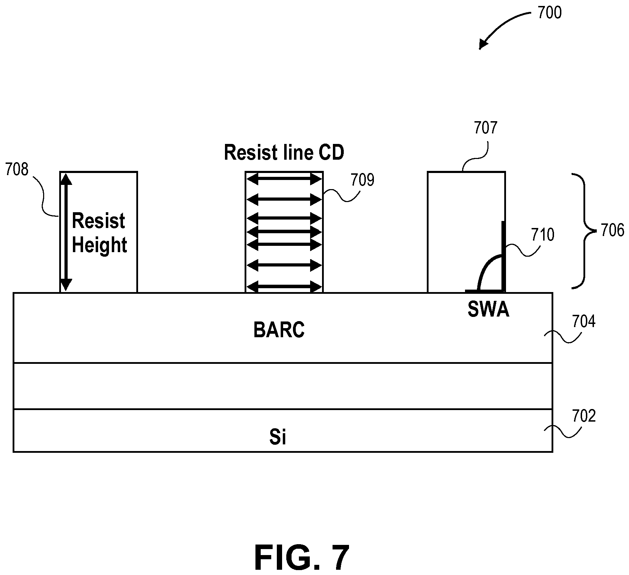

Figure 7 illustrates a cross-sectional view of a representative material stack 700 for which a material optical property for optical metrology is determined, in accordance with an embodiment of the present invention. Referring to Figure 7, a bottom anti-reflective coating (BARC) layer 704 is disposed above a silicon (Si) substrate 702. A resist layer 706 is disposed and patterned above BARC layer 704. The individual lines, e.g. line 707, of resist layer 706 has various properties, such as a resist height 708, a resist line critical dimension (CD) 709 and a resist line sidewall angle (SWA) 710. In a modeling example, in accordance with a specific embodiment of the present invention, for n,k refinement an n,k dispersion model is used for BARC layer 704 and resist layer 706. For the BARC layer 704, the Cauchy variables are A=1.45 and B=317140, while for the resist layer 706 the Cauchy variables are A=1.545, B= -3.10000, and C= 7.4 E12. The grating spectra are measured at 0 and 90 degrees for the azimuth angle.

In accordance with the present invention, n,k refinement is performed and a combination regression is used to refine n,k directly from a grating structure. For example, in one embodiment, 8 parameters are floated: 4 shape parameters and 4 dispersion parameters. A dispersion model may be in reasonable agreement with a model from a sequential film stack. Results may track expected Finite-Element Method (FEM) behavior. However, in one embodiment, for enhancement, an optimized film stack model is used as a starting point for grating structure refinement, but this need not be used in the test since the final film model is used as a checkpoint.

Figure 8 is an architectural diagram illustrating the utilization of optical metrology to determine the profiles of structures on a semiconductor wafer, in accordance with embodiments of the present invention. The optical metrology system 800 includes a metrology beam source 802 projecting a metrology beam 804 at the target structure 806 of a wafer 808. The metrology beam 804 is projected at an incidence angle θ towards the target structure 806. The diffraction beam 810 is measured by a metrology beam receiver 812. The diffraction beam data 814 is transmitted to a profile application server 816. The profile application server 816 compares the measured diffraction beam data 814 against a library 818 of simulated diffraction beam data representing varying combinations of critical dimensions of the target structure and resolution.

In accordance with an embodiment of the present invention, at least a portion of the simulated diffraction beam data is based on two or more azimuth angles and on one or more angles of incidence. In accordance with another embodiment of the present invention, at least a portion of the simulated diffraction beam data is based on two or more angles of incidence. In one exemplary embodiment, the library 818 instance best matching the measured diffraction beam data 814 is selected. It is to be understood that although a library of diffraction spectra or signals and associated hypothetical profiles is frequently used to illustrate concepts and principles, the present invention applies equally to a data space comprising simulated diffraction signals and associated sets of profile parameters, such as in regression, neural network, and similar methods used for profile extraction. The hypothetical profile and associated critical dimensions of the selected library 816 instance is assumed to correspond to the actual cross-sectional profile and critical dimensions of the features of the target structure 806. The optical metrology system 800 may utilize a reflectometer, an ellipsometer, or other optical metrology device to measure the diffraction beam or signal.

In order to facilitate the description of embodiments of the present invention, an ellipsometric optical metrology system is used to illustrate the above concepts and principles. It is to be understood that the same concepts and principles apply equally to the other optical metrology systems, such as reflectometric systems. In a similar manner, a semiconductor wafer may be utilized to illustrate an application of the concept. Again, the methods and processes apply equally to other work pieces that have repeating structures.

The present invention may be provided as a computer program product, or software, that may include a machine-readable medium having stored thereon instructions, which may be used to program a computer system (or other electronic devices) to perform a process according to the present invention. A machine-readable medium includes any mechanism for storing or transmitting information in a form readable by a machine (e.g., a computer). For example, a machine-readable (e.g., computer-readable) medium includes a machine (e.g., a computer) readable storage medium (e.g., read only memory ("ROM"), random access memory ("RAM"), magnetic disk storage media, optical storage media, flash memory devices, etc.), a machine (e.g., computer) readable transmission medium (electrical, optical, acoustical or other form of propagated signals (e.g., carrier waves, infrared signals, digital signals, etc.)), etc.

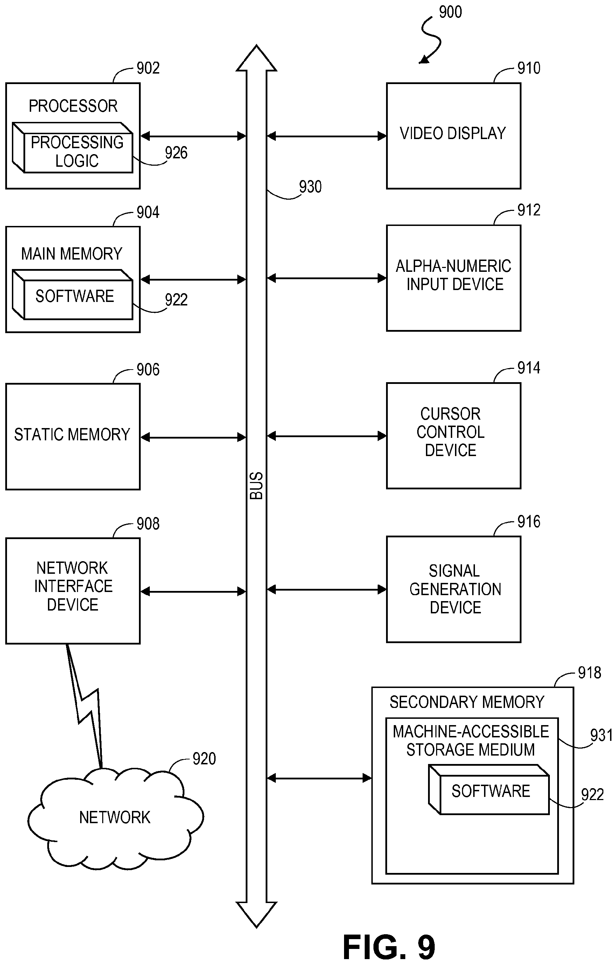

Figure 9 illustrates a diagrammatic representation of a machine in the exemplary form of a computer system 900 within which a set of instructions, for causing the machine to perform any one or more of the methodologies discussed herein, may be executed. In alternative embodiments, the machine may be connected (e.g., networked) to other machines in a Local Area Network (LAN), an intranet, an extranet, or the Internet. The machine may operate in the capacity of a server or a client machine in a client-server network environment, or as a peer machine in a peer-to-peer (or distributed) network environment. The machine may be a personal computer (PC), a tablet PC, a set-top box (STB), a Personal Digital Assistant (PDA), a cellular telephone, a web appliance, a server, a network router, switch or bridge, or any machine capable of executing a set of instructions (sequential or otherwise) that specify actions to be taken by that machine. Further, while only a single machine is illustrated, the term "machine" shall also be taken to include any collection of machines (e.g., computers) that individually or jointly execute a set (or multiple sets) of instructions to perform any one or more of the methodologies discussed herein.

The exemplary computer system 900 includes a processor 902, a main memory 904 (e.g., read-only memory (ROM), flash memory, dynamic random access memory (DRAM) such as synchronous DRAM (SDRAM) or Rambus DRAM (RDRAM), etc.), a static memory 906 (e.g., flash memory, static random access memory (SRAM), etc.), and a secondary memory 918 (e.g., a data storage device), which communicate with each other via a bus 930.

Processor 902 represents one or more general-purpose processing devices such as a microprocessor, central processing unit, or the like. More particularly, the processor 902 may be a complex instruction set computing (CISC) microprocessor, reduced instruction set computing (RISC) microprocessor, very long instruction word (VLIW) microprocessor, processor implementing other instruction sets, or processors implementing a combination of instruction sets. Processor 902 may also be one or more special-purpose processing devices such as an application specific integrated circuit (ASIC), a field programmable gate array (FPGA), a digital signal processor (DSP), network processor, or the like. Processor 902 is configured to execute the processing logic 926 for performing the operations and steps discussed herein.

The computer system 900 may further include a network interface device 908. The computer system 900 also may include a video display unit 910 (e.g., a liquid crystal display (LCD) or a cathode ray tube (CRT)), an alphanumeric input device 912 (e.g., a keyboard), a cursor control device 914 (e.g., a mouse), and a signal generation device 916 (e.g., a speaker).

The secondary memory 918 may include a machine-accessible storage medium (or more specifically a computer-readable storage medium) 931 on which is stored one or more sets of instructions (e.g., software 922) embodying any one or more of the methodologies or functions described herein. The software 922 may also reside, completely or at least partially, within the main memory 904 and/or within the processor 902 during execution thereof by the computer system 900, the main memory 904 and the processor 902 also constituting machine-readable storage media. The software 922 may further be transmitted or received over a network 920 via the network interface device 908.

While the machine-accessible storage medium 931 is shown in an exemplary embodiment to be a single medium, the term "machine-readable storage medium" should be taken to include a single medium or multiple media (e.g., a centralized or distributed database, and/or associated caches and servers) that store the one or more sets of instructions. The term "machine-readable storage medium" shall also be taken to include any medium that is capable of storing or encoding a set of instructions for execution by the machine and that cause the machine to perform any one or more of the methodologies of the present invention. The term "machine-readable storage medium" shall accordingly be taken to include, but not be limited to, solid-state memories, and optical and magnetic media.

In accordance with an embodiment of the present invention, a machine-accessible storage medium has instructions stored thereon which cause a data processing system to perform a method of determining a material optical property for optical metrology of a structure. The method includes simulating a set of diffraction orders for a grating structure based on two or more azimuth angles and on one or more angles of incidence. A simulated spectrum is then provided based on the set of diffraction orders. In one embodiment, simulating the set of diffraction orders for the grating structure includes using a dense grating structure in combination with an isolated structure. In one embodiment, simulating the set of diffraction orders for the grating structure includes using a two-dimensional grating structure. In one embodiment, simulating the set of diffraction orders for the grating structure includes using a three-dimensional grating structure. In one embodiment, simulating the set of diffraction orders is based on two or more angles of incidence. In one embodiment, the instructions stored thereon cause a data processing system to perform the method further including comparing the simulated spectrum to a sample spectrum.

In accordance with another embodiment of the present invention, a machine-accessible storage medium has instructions stored thereon which cause a data processing system to perform a method of determining a material optical property for optical metrology of a structure. The method includes simulating a set of diffraction orders for a grating structure based on two or more angles of incidence. A simulated spectrum is then provided based on the set of diffraction orders. In one embodiment, simulating the set of diffraction orders for the grating structure includes using a dense grating structure in combination with an isolated structure. In one embodiment, simulating the set of diffraction orders for the grating structure includes using a two-dimensional grating structure. In one embodiment, simulating the set of diffraction orders for the grating structure includes using a three-dimensional grating structure. In one embodiment, simulating the set of diffraction orders is further based on two or more azimuth angles. In one embodiment, the instructions stored thereon cause a data processing system to perform the method further including comparing the simulated spectrum to a sample spectrum.

In another aspect of the present invention, for optimizing the dispersion (n,k) of materials in a planar stack or grating stack, the material properties of certain layers may be exploited. For example, in accordance with an embodiment of the present invention, the following stack is considered (defined top down): photoresist grating/anti-reflective coating (ARC)/polysilicon/nitride/oxide/silicon. Polysilicon absorbs (blocks) light at a wavelength less than approximately 350 nanometers and is transmissive for wavelengths greater than approximately 350 nanometers. Therefore, in one embodiment, the dispersion of the photoresist grating and ARC layer is optimized using wavelengths below 350 nanometers (e.g., using multiple angles of incidence, azimuth angles, etc.) and then visible wavelengths are used for optimizing the materials below the polysilicon layers (e.g., nitride/oxide/silicon).

In an embodiment, the above described approach greatly simplifies the optimization problem by separating it into two much easier problems. In an embodiment, such an approach is also used for the measurement of grating parameters since the polysilicon can be used layer as a blocking material to "block" the underlying grating materials, greatly reducing the problem complexity in in-device measurements. Thus, in one embodiment, in one or more of the methods described above, the sample spectrum is generated from a grating structure including a plurality of material layers, at least one of the material layers blocking at least one other of the material layers during measurement of the grating structure in providing the sample spectrum. In another embodiment, in one or more of the methods described above, the sample spectrum is generated from a grating structure including a plurality of material layers, and measurement of the grating structure to provide the sample spectrum includes measuring the grating structure at two different wavelengths.

Thus, methods of determining material optical properties for optical metrology of structures have been disclosed. In accordance with the present invention, a method includes simulating a set of diffraction orders for a grating structure based on two or more azimuth angles and on one or more angles of incidence. A simulated spectrum is then provided based on the set of diffraction orders. In one embodiment, simulating the set of diffraction orders for the grating structure includes using a dense grating structure in combination with an isolated structure. In accordance with another embodiment of the present invention, a method includes simulating a set of diffraction orders for a grating structure based on two or more angles of incidence. A simulated spectrum is then provided based on the set of diffraction orders. In one embodiment, simulating the set of diffraction orders for the grating structure includes using a dense grating structure in combination with an isolated structure.

**Claims**

1. A method for determining a material optical property for optical metrology of a structure (300) comprising:

   Providing a grating structure in a metrology system;
   simulating a set of diffraction orders for a grating structure based on two or more azimuth angles and on one or more angles of incidence (302);
   providing a simulated spectrum based on the set of diffraction orders (304);
   comparing the simulated spectrum to a sample spectrum, wherein the sample spectrum is generated from said grating structure comprising a plurality of material layers,
   and wherein measurement of the structure to provide the sample spectrum comprises measuring the structure at two different wavelengths; and
   determining, from comparing the simulated spectrum to the sample spectrum, the index of refractivity and coefficient of extinction material optical properties of said grating structure.

2. The method of claim 1, wherein simulating the set of diffraction orders is based on two or more angles of incidence.

3. A method for determining a material optical property for optical metrology of a structure (500) comprising:

   Providing a grating structure in a metrology system;
   Simulating a set of diffraction orders for a grating structure based on two or more angles of incidence (502);
   Providing a simulated spectrum based on the set of diffraction orders (504);
   comparing the simulated spectrum to a sample spectrum, wherein the sample spectrum is generated from said grating structure comprising a plurality of material layers,
   and wherein measurement of the structure to provide the sample spectrum comprises measuring the structure at two different wavelengths;
   determining, from comparing the simulated spectrum to the sample spectrum, the index of refractivity and coefficient of extinction material optical properties of said grating structure.

4. The method of claim 1 or claim 3, wherein simulating the set of diffraction orders for the grating structure comprises using a two-dimensional grating structure.

5. The method of claim 1 or claim 3, wherein simulating the set of diffraction orders for the grating structure comprises using a three-dimensional grating structure.

6. The method of claim 3, wherein simulating the set of diffraction orders is further based on two or more azimuth angles.

7. A machine-accessible storage medium having instructions stored thereon which cause a data processing system to perform a method for determining a material optical property for optical metrology of a structure (300) comprising:

   Simulating a set of diffraction orders for a grating structure based on two or more azimuth angles and on one or more angles of incidence (302);
   Providing a simulated spectrum based on the set of diffraction orders (304);
   Comparing the simulated spectrum to a sample spectrum, wherein the sample spectrum is generated from a grating structure comprising a plurality of material layers,
   and wherein measurement of the structure to provide the sample spectrum comprises measuring the structure at two different wavelengths; and
   determining, from comparing the simulated spectrum to the sample spectrum, the index of refractivity and coefficient of extinction material optical properties of said grating structure.

8. The storage medium in claim 7, wherein simulating the set of diffraction orders is based on two or more angles of incidence.

9. A machine-accessible storage medium having instructions stored thereon which cause a data processing system to perform a method for determining a material optical property for optical metrology of a structure (500) comprising:

   Simulating a set of diffraction orders for a grating structure based on two or more angles of incidence (502);
   Providing a simulated spectrum based on the set of diffraction orders (504);

Comparing the simulated spectrum to a sample spectrum, wherein the sample spectrum is generated from a grating structure comprising a plurality of material layers,
and wherein measurement of the structure to provide the sample spectrum comprises measuring the structure at two different wavelengths; and
determining, from comparing the simulated spectrum to the sample spectrum, the index of refractivity and coefficient of extinction material optical properties of said grating structure.

10. The storage medium as in claim 7 or claim 9, wherein simulating the set of diffraction orders for the grating structure comprises using a two-dimensional grating structure, using a three-dimensional grating structure.

11. The storage medium as in claim 9, wherein simulating the set of diffraction orders is further based on two or more azimuth angles.

**Patentansprüche**

1. Verfahren zum Bestimmen einer optischen Materialeigenschaft zur optischen Messung einer Struktur (300), Folgendes umfassend:

Bereitstellen einer Gitterstruktur in einem Messsystem;
Simulieren eines Satzes von Beugungsordnungen für eine Gitterstruktur basierend auf zwei oder mehreren Azimutwinkeln und einem oder mehreren Einfallswinkeln (302);
Bereitstellen eines simulierten Spektrums basierend auf dem Satz von Beugungsordnungen (304);
Vergleichen des simulierten Spektrums mit einem Probenspektrum, wobei das Probenspektrum aus der Gitterstruktur, die eine Vielzahl von Materialschichten umfasst, erzeugt wird,
und wobei die Messung der Struktur zur Bereitstellung des Probenspektrums die Messung der Struktur bei zwei verschiedenen Wellenlängen umfasst; und
Bestimmen der optischen Eigenschaften Brechungsindex und Extinktionskoeffizient der Gitterstruktur durch Vergleich des simulierten Spektrums mit dem Probenspektrum.

2. Verfahren nach Anspruch 1, wobei das Simulieren des Satzes von Beugungsordnungen auf zwei oder mehr Einfallswinkeln basiert.

3. Verfahren zum Bestimmen einer optischen Materialeigenschaft zur optischen Messung einer Struktur (500), Folgendes umfassend:

Bereitstellen einer Gitterstruktur in einem Messsystem;
Simulieren eines Satzes von Beugungsordnungen für eine Gitterstruktur basierend auf zwei oder mehreren Einfallswinkeln (502);
Bereitstellen eines simulierten Spektrums basierend auf dem Satz von Beugungsordnungen (504);
Vergleichen des simulierten Spektrums mit einem Probenspektrum, wobei das Probenspektrum aus der Gitterstruktur, die eine Vielzahl von Materialschichten umfasst, erzeugt wird,
und wobei die Messung der Struktur zur Bereitstellung des Probenspektrums die Messung der Struktur bei zwei verschiedenen Wellenlängen umfasst;
Bestimmen der optischen Eigenschaften Brechungsindex und Extinktionskoeffizient der Gitterstruktur durch Vergleich des simulierten Spektrums mit dem Probenspektrum.

4. Verfahren nach Anspruch 1 oder 3, wobei das Simulieren des Satzes von Beugungsordnungen für die Gitterstruktur die Verwendung einer zweidimensionalen Gitterstruktur umfasst.

5. Verfahren nach Anspruch 1 oder 3, wobei das Simulieren des Satzes von Beugungsordnungen für die Gitterstruktur die Verwendung einer dreidimensionalen Gitterstruktur umfasst.

6. Verfahren nach Anspruch 3, wobei das Simulieren des Satzes von Beugungsordnungen ferner auf zwei oder mehr Azimutwinkeln basiert.

7. Maschinenzugängliches Speichermedium, das darauf gespeicherte Anweisungen aufweist, die ein Datenverarbeitungssystem veranlassen, ein Verfahren zur Bestimmung einer optischen Materialeigenschaft zur optischen Messung einer Struktur (300) durchzuführen, Folgendes umfassend:

Simulieren eines Satzes von Beugungsordnungen für eine Gitterstruktur basierend auf zwei oder mehreren Azimutwinkeln und einem oder mehreren Einfallswinkeln (302);

Bereitstellen eines simulierten Spektrums basierend auf dem Satz von Beugungsordnungen (304);

Vergleichen des simulierten Spektrums mit einem Probenspektrum, wobei das Probenspektrum aus einer Gitterstruktur, die eine Vielzahl von Materialschichten umfasst, erzeugt wird,

und wobei die Messung der Struktur zur Bereitstellung des Probenspektrums die Messung der Struktur bei zwei verschiedenen Wellenlängen umfasst; und

Bestimmen der optischen Eigenschaften Brechungsindex und Extinktionskoeffizient der Gitterstruktur durch Vergleich des simulierten Spektrums mit dem Probenspektrum.

8. Speichermedium nach Anspruch 7, wobei das Simulieren des Satzes von Beugungsordnungen auf zwei oder mehr Einfallswinkeln basiert.

9. Maschinenzugängliches Speichermedium, das darauf gespeicherte Anweisungen aufweist, die ein Datenverarbeitungssystem veranlassen, ein Verfahren zur Bestimmung einer optischen Materialeigenschaft zur optischen Messung einer Struktur (500) durchzuführen, Folgendes umfassend:

Simulieren eines Satzes von Beugungsordnungen für eine Gitterstruktur basierend auf zwei oder mehreren Einfallswinkeln (502);

Bereitstellen eines simulierten Spektrums basierend auf dem Satz von Beugungsordnungen (504);

Vergleichen des simulierten Spektrums mit einem Probenspektrum, wobei das Probenspektrum aus einer Gitterstruktur, die eine Vielzahl von Materialschichten umfasst, erzeugt wird,

und wobei die Messung der Struktur zur Bereitstellung des Probenspektrums die Messung der Struktur bei zwei verschiedenen Wellenlängen umfasst; und

Bestimmen der optischen Eigenschaften Brechungsindex und Extinktionskoeffizient der Gitterstruktur durch Vergleich des simulierten Spektrums mit dem Probenspektrum.

10. Speichermedium nach Anspruch 7 oder 9, wobei das Simulieren des Satzes von Beugungsordnungen für die Gitterstruktur die Verwendung einer zweidimensionalen Gitterstruktur, die Verwendung einer dreidimensionalen Gitterstruktur umfasst.

11. Speichermedium nach Anspruch 9, wobei das Simulieren des Satzes von Beugungsordnungen ferner auf zwei oder mehr Azimutwinkeln basiert.

**Revendications**

1. Procédé de détermination d'une propriété optique de matériau pour la métrologie optique d'une structure (300) comprenant :

La fourniture d'une structure de réseau dans un système de métrologie ;

la simulation d'un ensemble d'ordres de diffraction pour une structure de réseau sur la base de deux angles d'azimut ou plus et d'un ou plusieurs angles d'incidence (302) ;

la fourniture d'un spectre simulé sur la base de l'ensemble d'ordres de diffraction (304) ;

la comparaison du spectre simulé à un spectre d'échantillon, dans lequel le spectre d'échantillon est généré à partir de ladite structure de réseau comprenant une pluralité de couches de matériau,

et dans lequel la mesure de la structure pour fournir le spectre d'échantillon comprend la mesure de la structure au niveau de deux longueurs d'onde différentes ; et

la détermination, à partir de la comparaison du spectre simulé au spectre d'échantillon, des propriétés optiques de matériau d'indice de réfraction et de coefficient d'extinction de ladite structure de réseau.

2. Procédé selon la revendication 1, dans lequel la simulation de l'ensemble d'ordres de diffraction est basée sur deux angles d'incidence ou plus.

3. Procédé de détermination d'une propriété optique de matériau pour la métrologie optique d'une structure (500) comprenant :

La fourniture d'une structure de réseau dans un système de métrologie ;

La simulation d'un ensemble d'ordres de diffraction pour une structure de réseau sur la base de deux angles d'incidence (502) ou plus ;

La fourniture d'un spectre simulé sur la base de l'ensemble d'ordres de diffraction (504) ;

la comparaison du spectre simulé à un spectre d'échantillon, dans lequel le spectre d'échantillon est généré à partir de ladite structure de réseau comprenant une pluralité de couches de matériau,

et dans lequel la mesure de la structure pour fournir le spectre d'échantillon comprend la mesure de la structure au niveau de deux longueurs d'onde différentes ;

la détermination, à partir de la comparaison du spectre simulé au spectre d'échantillon, des propriétés optiques de matériau d'indice de réfraction et de coefficient d'extinction de ladite structure de réseau.

4.  Procédé selon la revendication 1 ou la revendication 3, dans lequel la simulation de l'ensemble d'ordres de diffraction pour la structure de réseau comprend l'utilisation d'une structure de réseau bidimensionnelle.

5.  Procédé selon la revendication 1 ou la revendication 3, dans lequel la simulation de l'ensemble d'ordres de diffraction pour la structure de réseau comprend l'utilisation d'une structure de réseau tridimensionnelle.

6.  Procédé selon la revendication 3, dans lequel la simulation de l'ensemble d'ordres de diffraction est en outre basée sur deux angles d'azimut ou plus.

7.  Support de stockage accessible par une machine sur lequel sont stockées des instructions qui amènent un système de traitement de données à mettre en œuvre un procédé de détermination d'une propriété optique de matériau pour la métrologie optique d'une structure (300) comprenant :

La simulation d'un ensemble d'ordres de diffraction pour une structure de réseau sur la base de deux angles d'azimut ou plus et d'un ou plusieurs angles d'incidence (302) ;

La fourniture d'un spectre simulé sur la base de l'ensemble d'ordres de diffraction (304) ;

La comparaison du spectre simulé à un spectre d'échantillon, dans lequel le spectre d'échantillon est généré à partir d'une structure de réseau comprenant une pluralité de couches de matériau,

et dans lequel la mesure de la structure pour fournir le spectre d'échantillon comprend la mesure de la structure au niveau de deux longueurs d'onde différentes ; et

la détermination, à partir de la comparaison du spectre simulé au spectre d'échantillon, des propriétés optiques de matériau d'indice de réfraction et de coefficient d'extinction de ladite structure de réseau.

8.  Support de stockage selon la revendication 7, dans lequel la simulation de l'ensemble d'ordres de diffraction est basée sur deux angles d'incidence ou plus.

9.  Support de stockage accessible par une machine sur lequel sont stockées des instructions qui amènent un système de traitement de données à mettre en œuvre un procédé de détermination d'une propriété optique de matériau pour la métrologie optique d'une structure (500) comprenant :

La simulation d'un ensemble d'ordres de diffraction pour une structure de réseau sur la base de deux angles d'incidence (502) ou plus ;

La fourniture d'un spectre simulé sur la base de l'ensemble d'ordres de diffraction (504) ;

La comparaison du spectre simulé à un spectre d'échantillon, dans lequel le spectre d'échantillon est généré à partir d'une structure de réseau comprenant une pluralité de couches de matériau,

et dans lequel la mesure de la structure pour fournir le spectre d'échantillon comprend la mesure de la structure au niveau de deux longueurs d'onde différentes ; et

la détermination, à partir de la comparaison du spectre simulé au spectre d'échantillon, des propriétés optiques de matériau d'indice de réfraction et de coefficient d'extinction de ladite structure de réseau.

10. Support de stockage selon la revendication 7 ou la revendication 9, dans lequel la simulation de l'ensemble d'ordres de diffraction pour la structure de réseau comprend l'utilisation d'une structure de réseau bidimensionnelle, l'utilisation d'une structure de réseau tridimensionnelle.

11. Support de stockage selon la revendication 9, dans lequel la simulation de l'ensemble d'ordres de diffraction est en outre basée sur deux angles d'azimut ou plus.

FLOWCHART 100

DEVELOP A LIBRARY OR TRAINED MLS FOR PROFILE PARAMETER EXTRACTION FROM DIFFRACTION SIGNALS — 102

DETERMINE AT LEAST ONE PROFILE PARAMETER USING A LIBRARY OR MLS — 104

TRANSMIT AT LEAST ONE PROFILE PARAMETER TO A FABRICATION CLUSTER — 106

USE AT LEAST ONE TRANSMITTED PROFILE PARAMETER TO MODIFY A PROCESS VARIABLE OR EQUIPMENT SETTING OF A FABRICATION CLUSTER — 108

# FIG. 1

200

| 202 | FIRST FABRICATION CLUSTER | | SECOND FABRICATION CLUSTER | 206 |

| 216 | METROLOGY PROCESSOR |

OPTICAL METROLOGY SYSTEM | 204

| OPTICAL METROLOGY TOOL | 208 |

| PROCESSOR | 210 |

| LIBRARY | 210 |

| FIRST MLS | 214 |

# FIG. 2

FLOWCHART 300

START

SIMULATE A SET OF DIFFRACTION ORDERS FOR A GRATING STRUCTURE BASED ON TWO OR MORE AZIMUTH ANGLES AND ON ONE OR MORE ANGLES OF INCIDENCE — 302

PROVIDE A SIMULATED SPECTRUM BASED ON THE SET OF DIFFRACTION ORDERS — 304

FINISH

# FIG. 3

FLOWCHART 500

START

SIMULATE A SET OF DIFFRACTION ORDERS FOR A GRATING STRUCTURE BASED ON TWO OR MORE ANGLES OF INCIDENCE — 502

PROVIDE A SIMULATED SPECTRUM BASED ON THE SET OF DIFFRACTION ORDERS — 504

FINISH

# FIG. 5

**FIG. 4A**

**FIG. 4B**

**FIG. 6**

**FIG. 7**

**FIG. 8**

900

902

PROCESSOR

PROCESSING
LOGIC
926

904

MAIN MEMORY

SOFTWARE
922

906

STATIC MEMORY

908

NETWORK
INTERFACE
DEVICE

920

NETWORK

930

BUS

910

VIDEO DISPLAY

912

ALPHA-NUMERIC
INPUT DEVICE

914

CURSOR
CONTROL
DEVICE

916

SIGNAL
GENERATION
DEVICE

918

SECONDARY MEMORY

MACHINE-ACCESSIBLE
STORAGE MEDIUM

SOFTWARE

931

922

**FIG. 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010042388 A
- US 2008129986 A
- US 60830003
- US 38826506